# EUROPÄISCHE PATENTSCHRIFT

(11) **EP 0 524 460 B1**
(45) Veröffentlichungstag und Bekanntmachung des Hinweises auf die Patenterteilung: **11.06.1997**
(21) Anmeldenummer: 92111169.6
(22) Anmeldetag: 01.07.1992
(51) Int. Cl.: H04B 1/034, H05K 7/14

(54) **Gehäuse für ein Handfunksprechgerät**
Housing for a handheld radio transceiver
Boîtier pour un émetteur-récepteur portable

(30) Priorität: 23.07.1991 DE 9109072 U
(43) Veröffentlichungstag der Anmeldung: 27.01.1993
(73) Patentinhaber: SIEMENS AKTIENGESELLSCHAFT, 80333 München (DE)
(72) Erfinder: Kiesewetter, Reinhold, W-8056 Neufahrn (DE); Dafcik, Juan, Dipl. Ing., W-8000 München 82 (DE)

(56) Entgegenhaltungen:
- EP-A- 0 381 378
- EP-A- 0 393 236
- EP-A- 0 394 053
- US-A- 4 717 989
- US-A- 4 831 498
- US-A- 4 890 199

## Beschreibung

Die Erfindung bezieht sich auf ein Gehäuse für ein Handfunksprechgerät.

Derartige Handfunksprechgeräte werden heute zufolge der Entwicklung der elektronischen Bauelemente in immer kleineren Dimensionen gefertigt, wobei eine möglichst große Schirmwirkung der HF-Bauelemente erzielt werden soll.

Der Erfindung liegt die Aufgabe zugrunde, ein möglichst kompaktes und leicht zu montierendes Gehäuse für ein solches Handfunksprechgerät anzugeben, bei dem eine hohe Schirmwirkung der HF-Bauelemente gegeben ist. Diese Aufgabe wird bei einem Handfunksprechgerät gemäß der Erfindung durch die im Patentanspruch 1 angegebenen Merkmale gelöst.

Das erfindungsgemäße Handfunksprechgerät zeichnet sich durch ein kompaktes und leicht zu montierendes Gehäuse aus, welches eine vollständige elektromagnetische Abschirmung der Baugruppen untereinander ermöglicht.

Aus der EP-A-0 394 053 ist zwar ein tragbares Mobilfunkgerät bekannt, welches zwei Wannen mit einem gemeinsamen Boden zur Aufnahme der Bauelemente aufweist. Jedoch sind hier die Bauelemente mit ihrer Leiterplatte auf jeweils auf dem gemeinsamen Wannenboden befestigt, was zu einer schwierigeren Montage des Geräts führt. Auch ist bei diesem Gerät keine Aufteilung der Wannen in verschiedene Kammern vorgesehen.

Nachstehend wird die Erfindung anhand zweier in den Figuren dargestellten Ausführungsbeispiele näher erläutert.

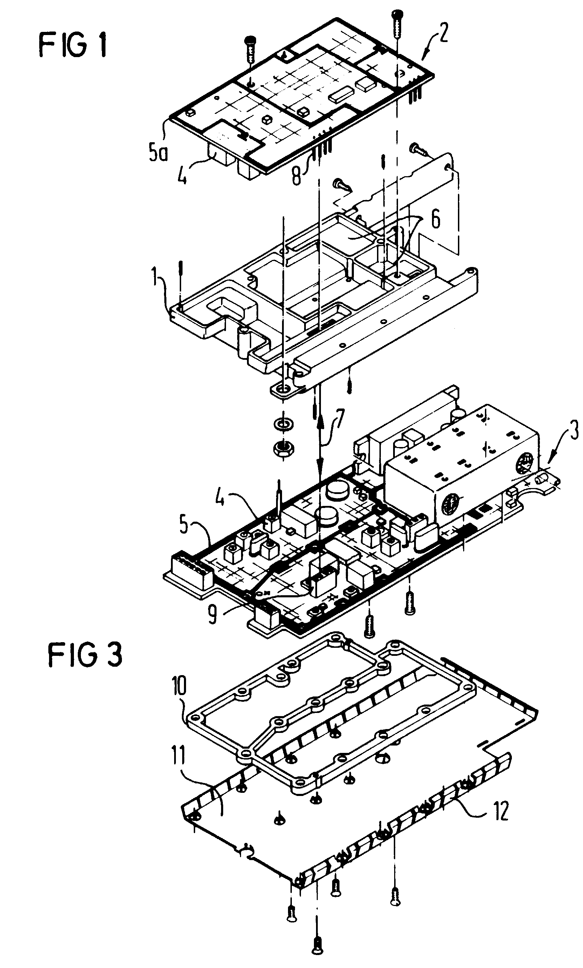

- Die Figur 1: zeigt den prinzipiellen Aufbau des Grundchassis.
- Die Figur 2: zeigt in Explosionsdarstellung die Einzelheiten des Grundchassis mit wannenförmigen Abschirmdeckeln.
- Die Figur 3: zeigt eine Ausführung des Deckels bestehend aus einem Distanzrahmen und einem Blechdeckel.
- Die Figur 4: zeigt eine komplette Ausführung.

Das Gehäuseinnere eines Handfunksprechgeräts besteht im wesentlichen aus einem vorzugsweise gegossenem Grundchassis, das aus zwei wannenförmigen Elementen 1 mit gemeinsamen Boden gebildet wird. In die Wannen sind beidseits Leiterplatten 2 und 3 so eingesetzt, daß die Bauelemente 4 in das Wanneninnere ragen. Dabei befinden sich in jeder der Wannen an den für die Abschirmung einzelner Geräteteile erforderlichen Stellen Kammern 6. Entlang der Konturen der Kammerwände sind auf der Bauelementeseite Massebahnen 5 vorgesehen, die, nach dem Zusammenbau, in zum Beispiel mittels Verschraubung auf die Konturen der Kammern 6 derart aufgepreßt werden, daß den Abschirmbedingungen Genüge geleistet ist.

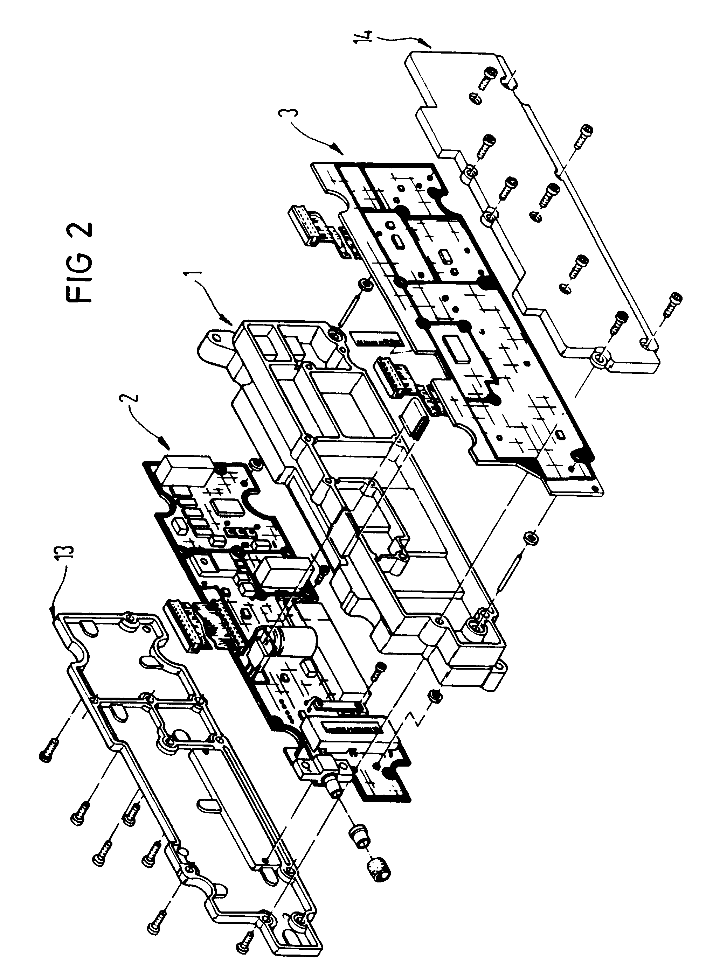

Auch auf der nach außen weisenden Leiterbahnseite der Leiterplatten 2, 3 sind solche Massebahnen 5a, vorzugsweise in der gleichen Art und Anordnung wie auf der Bauelementeseite der Platten vorgesehen. Auf diese werden gemäß Ausführungsbeispiel nach Figur 2 wannenförmige Abschirmdeckel 13, 14, die ebenfalls kammerförmig unterteilt sind, mittels Schrauben aufgepreßt. Die Tiefe dieser wannenförmigen Deckel ist so bemessen, daß keinerlei Kurzschlüsse zwischen den auf der Leiterplatte befindlichen und darüber hinaus ragenden Lötzapfen entstehen. In den Deckeln können sich am Boden für den letzterwähnten Zweck auch Isolierschichten befinden.

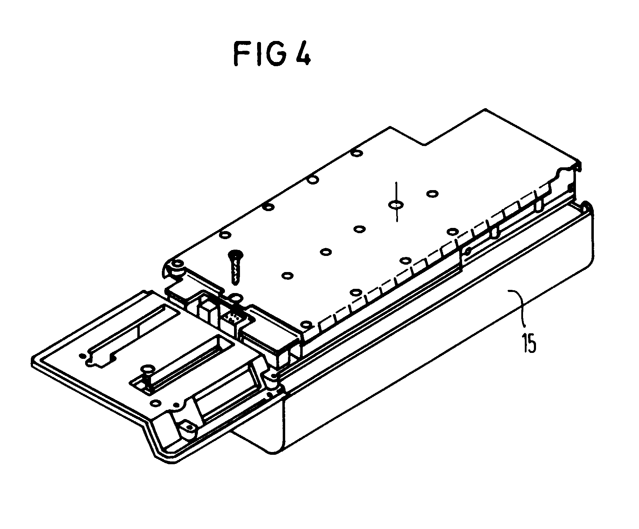

Eine weitere Ausführung für die Herstellung eines derartigen Deckels ist in der Figur 3 dargestellt. Dabei besteht der Deckel aus einem vorzugsweise gegossenen Distanzrahmen 10, der mittels eines einfachen Abschirmbleches 11 abgedeckt ist. Dieser Abschirmdeckel 11 hat längs seines Randes gefiederte Ränder 12, so daß beim Aufsetzen von je einer Grundgehäuseschale 15 auf das Grundchassis eine gute elektrische Kontaktierung zwischen beiden Teilen erreicht wird.

In Figur 4 ist nur ein Teil dieses Grundgehäuses 15 dargestellt.

Erforderliche Durchkontaktierungen zwischen den beiden Leiterplatten sind durch den Doppelpfeil 7 angedeutet und bestehen zweckmäßig aus einem Steckerteil 8 auf der Innenleiterplatte und im Buchsenteil 9 auf der anderen Leiterplatte. Zur Abschirmung ist dann jeweils eine entsprechende Kammer mit Durchbruch zur anderen Seite in der Doppelwanne vorgesehen.

## Patentansprüche

1. Gehäuse für ein Handfunksprechgerät, **dadurch gekennzeichnet,** daß im Gehäuseinneren ein Grundchassis angeordnet ist, das aus zwei in Kammern unterteilten Wannen (1) mit einem gemeinsamen Boden besteht,
daß in jede dieser Wannen eine Leiterplatte (2, 3) so eingesetzt ist, daß die Bauelemente in diese Kammern hineinragen, daß die Leiterbahnseiten der Leiterplatten (2, 3) durch Abschirmdeckel abgedeckt sind, und
daß die Leiterplatten (2, 3) auf ihrer Baugruppenseite Masseleiterbahnstreifen (5) aufweisen, die entsprechend den jeweiligen Konturen der Wannen des Grundchassis ausgebildet sind und nach dem Zusammenbau auf diesen Konturen kontaktgebend aufliegen.

2. Gehäuse für ein Handfunksprechgerät nach Anspruch 1, **dadurch gekennzeichnet,** daß kompakte Deckel (13, 14), insbesondere aus Spritzguß, vorgesehen sind, die ebenfalls wannenförmig gestaltet sind und an den für die Abschirmung erforderlichen Stellen Konturen aufweisen, mit denen sie auf Masseleiterbahnstreifen (5a) der Leiterbahnseite der Leiterplatten (2, 3) aufdrückbar sind.

3. Gehäuse für ein Handfunksprechgerät nach Anspruch 2, **dadurch gekennzeichnet,** daß einer der Deckel aus einem Distanzrahmen (10) besteht, der nach außen hin durch einen aufgesetzten Blechdeckel (11) verschließbar ist.

4. Gehäuse für ein Handfunksprechgerät nach einem der vorhergehenden Ansprüche, **dadurch gekennzeichnet**, daß erforderliche Durchkontaktierungen zwischen den beiden Leiterplatten (2, 3) durch den gemeinsamen Boden vorzugsweise steckbar hindurchgeführt sind.

## Claims

1. Housing for a handheld radio transceiver, characterized in that arranged in the interior of the housing is a base frame which comprises two troughs (1) which are divided into chambers and have a common floor, in that a printed circuit board (2, 3) is inserted into each of these troughs in such a way that the components project into these chambers,
in that the conductor track sides of the printed circuit boards (2, 3) are covered by screening covers, and
in that the printed circuit boards (2, 3) have on their assembly side earth conductor track strips (5) which are constructed in accordance with the respective contours of the troughs of the base frame and, after assembly, rest on these contours in a contact-forming fashion.

2. Housing for a handheld radio transceiver according to Claim 1, characterized in that compact covers (13, 14), in particular made of injection-moulded material, are provided which are likewise trough-shaped and have, at the points necessary for the screening, contours with which they can be pressed onto earth conductor track strips (5a) of the conductor track side of the printed circuit boards (2, 3).

3. Housing for a handheld radio transceiver according to Claim 2, characterized in that one of the covers comprises a spacing frame (10) which can be closed off from the outside by means of a fitted-on sheet-metal cover (11).

4. Housing for a handheld radio transceiver according to one of the preceding claims, characterized in that necessary through-contacts between the two printed circuit boards (2, 3) are led, preferably in a pluggable fashion, through the common floor.

## Revendications

1. Boîtier pour un émetteur-récepteur portable, caractérisé en ce qu'à l'intérieur du boîtier il est disposé un châssis de base, qui est composé de deux cuvettes (1) subdivisées en compartiments ayant un fond commun,
en ce qu'une carte à circuits imprimés (2, 3) est placée dans chacune de ces cuvettes, de sorte que les composants pénètrent dans ces compartiments,
en ce que les côtés des pistes conductrices des cartes à circuits imprimés (2, 3) sont recouverts de couvercles de blindage, et
en ce que les cartes à circuits imprimés (2, 3) comportent, sur leur côté ayant des composants, des pistes conductrices de mise à la masse (5), qui sont adaptées aux contours respectifs des cuvettes du châssis de base et, après assemblage, reposent sur ces contours de manière à établir un contact.

2. Boîtier pour un émetteur-récepteur portable selon la revendication 1, caractérisé en ce qu'il est prévu des couvercles (13, 14) peu encombrants, en particulier moulés par injection, qui sont réalisés eux aussi en forme de cuvette et qui comportent aux endroits nécessaires au blindage des contours permettant leur application sur des pistes conductrices de mise à la masse (5a) placées sur le côté des pistes conductrices des cartes à circuits imprimés (2, 3).

3. Boîtier pour un émetteur-récepteur portable selon la revendication 2, caractérisé en ce que l'un des couvercles est composé d'un cadre d'entretoisement (10) qui peut être fermé vers l'extérieur par un couvercle en tôle (11) rapporté.

4. Boîtier pour un émetteur-récepteur portable selon l'une des revendications précédentes, caractérisé en ce que des interconnexions nécessaires entre les deux cartes à circuits imprimées (2, 3) passent, de préférence par enfichage, à travers le fond commun.
